# EUROPÄISCHE PATENTSCHRIFT

(11) **EP 1 767 770 B1**
(45) Veröffentlichungstag und Bekanntmachung des Hinweises auf die Patenterteilung: **13.08.2008**
(21) Anmeldenummer: 06118980.9
(22) Anmeldetag: 16.08.2006
(51) Int. Cl.: F02M 51/06, H01L 41/047, H01L 41/083

(54) **Piezoelektrischer Aktor**
Piezoelectric actuator
Actionneur piézo-électrique

(30) Priorität: 27.09.2005 DE 102005046121
(43) Veröffentlichungstag der Anmeldung: 28.03.2007
(73) Patentinhaber: ROBERT BOSCH GMBH, 70442 Stuttgart (DE)
(72) Erfinder: Boecking, Friedrich, 70499 Stuttgart (DE)

(56) Entgegenhaltungen:
- EP-A2- 0 448 349
- DE-A1- 19 856 202
- DE-A1- 19 913 271
- GB-A- 2 258 084

## Beschreibung

### Stand der Technik

Die Erfindung betrifft einen piezoelektrischen Aktor für ein Brennstoffeinspritzventil, ein Verfahren zur Herstellung eines piezoelektrischen Aktors und ein Brennstoffeinspritzventil mit solch einem piezoelektrischen Aktor. Speziell betrifft die Erfindung das Gebiet der Injektoren für Brennstoffeinspritzanlagen von luftverdichtenden, selbstzündenden Brennkraftmaschinen.

Aus der DE 198 56 202 A1 ist ein piezoelektrischer Aktor bekannt. Der bekannte piezoelektrische Aktor dient insbesondere zur Betätigung von Einspritzventilen an Verbrennungsmotoren in Kraftfahrzeugen. Der bekannte Aktor weist einen piezoelektrischen Aktorkörper in Form eines vielschichtigen Laminats aus aufeinander geschichteten Lagen piezoelektrischen Materials und dazwischen liegenden metallischen beziehungsweise elektrisch leitenden als Elektroden dienenden Schichten auf. Eine Elektrodenzuleitung zur Kontaktierung der als Elektroden dienenden Schichten ist seitlich an den Aktorkörper geführt und durch einen Elastomermantel oder Schrumpfschlauch vor direkter Luftfeuchte geschützt.

Der aus der DE 198 56 202 A1 bekannte Aktor hat den Nachteil, dass eine Nachbearbeitung der Außenfläche des Aktors, insbesondere durch Schleifen, erforderlich ist, um einen Bereich zur Verbindung der Elektrodenzuleitung mit dem Aktorkörper zu schaffen.

Aus der DE 102 31 470 A1 ist eine Werkstoff-Mischstofftechnik zur Bildung und Korrektur der Zusammensetzung von einphasigen Mehrkomponenten-Werkstoffen bekannt. Speziell kann die bekannte Mischtechnik zur Fertigung piezoelektrischer Keramiken auf der Basis von Bleizirkonattitanat eingesetzt werden.

Aus der GB 2 258 084 A ist bereits ein piezoelektrischer Aktor bekannt, der einen Aktorkörper aufweist, der eine Vielzahl von keramischen Schichten und eine Vielzahl von zwischen den keramischen Schichten angeordneten Elektrodenschichten besitzt. Außerdem umfasst der piezoelektrische Aktor zumindest eine erste Elektrodenanbindung als Außenelektrode, wobei die erste Elektrodenanbindung mehrere Isolierabschnitte innerhalb der metallischen Außenetektrodenstruktur aufweist, die z.B. aus Glasstaub bestehen. Diese Isolierabschnitte sind über die erste Elektrodenanbindung verteilt im Bereich der jeweils nicht zu kontaktierenden Innenelektroden angeordnet. Dabei sind die Isolierabschnitte der ersten Elektrodenanbindung auch in gewisser Weise mit dem Aktorkörper verbunden.

### Vorteile der Erfindung

Der erfindungsgemäße piezoelektrische Aktor mit den Merkmalen des Anspruchs 1, das erfindungsgemäße Brennstoffeinspritzventil mit den Merkmalen des Anspruchs 9 und das erfindungsgemäße Verfahren mit den Merkmalen des Anspruchs 10 haben demgegenüber den Vorteil, dass eine aufwendige Nachbearbeitung des Aktorkörpers für die Elektrodenanbindung nicht erforderlich ist. Insbesondere können aufwendige Schleifprozesse im Hinblick auf den für die Elektrodenanbindung benötigten Bereich entfallen.

Die erste Elektrodenanbindung kann als außenliegende Elektrodenanbindung ausgestaltet sein. Durch die erfindungsgemäße Ausgestaltung des piezoelektrischen Aktors ist auf Grund der Haftbestandteile eine mechanische Verbindung der ersten Elektrodenanbindung mit dem Aktorkörper geschaffen, die eine relativ hohe Festigkeit aufweist. Dadurch eignet sich der erfindungsgemäße piezoelektrische Aktor auch zur Anordnung in einem Aktorraum, in dem Brennstoff unter hohem Druck vorgesehen ist.

Vorteilhaft ist, dass die erste Elektrodenanbindung ein elektrisch leitendes Grundmaterial aufweist und dass die Haftbestandteile der ersten Elektrodenanbindung in das elektrisch leitende Grundmaterial eingebettet sind. Eine Zusammensetzung des Grundmaterials der ersten Elektrodenanbindung ist dabei ähnlich zu einer Zusammensetzung eines Grundmaterials der Elektrodenschichten des Aktorkörpers. Durch die eingebetteten Haftbestandteile wird eine zuverlässige mechanische Befestigung des Grundmaterials und der Haftbestandteile der Elektrodenanbindung mit dem Aktorkörper ermöglicht. Für das Grundmaterial der ersten Elektrodenanbindung kann insbesondere eine Mischung aus Silber und Palladium oder Kupfer ohne eine Glasphase zum Einsatz kommen. Die Korngröße und die Menge der aus dem keramischen Material gebildeten Haftbestandteile, mit denen das Grundmaterial der ersten Elektrodenanbindung versetzt ist, wird der Schichtdicke und der Zusammensetzung des Grundmaterials der ersten Elektrodenanbindung angepasst. Die Haftbestandteile der ersten Elektrodenanbindung können beispielsweise auf Bleizirkonattitanat oder Bariumtitanat basieren.

Durch die in den Unteransprüchen aufgeführten Maßnahmen sind vorteilhafte Weiterbildungen des im Anspruch 1 angegebenen piezoelektrischen Aktors, des im Anspruch 9 angegebenen Brennstoffeinspritzventils und des im Anspruch 10 angegebenen Verfahrens möglich.

Zumindest ein Teil des für die Außenelektroden vorgesehenen Materials wird vor dem Sintern und Entbindern mit dem rohen Aktorkörper zusammengebracht. Nach dem Sintern kann die erste Elektrodenanbindung zusätzlich mit einem elektrisch leitenden Leitmittel, insbesondere einem Leitmittel aus einem elektrisch leitenden Klebstoff, einem elektrisch leitenden Sieb, einem Blech, einem Lot und/oder einer elektrisch leitenden, elastischen Struktur oder einer anderen flexiblen Struktur oder dergleichen verbunden werden. Diese Verbindung kann durch Kleben, Löten oder dergleichen erfolgen.

### Zeichnung

Ein bevorzugtes Ausführungsbeispiel der Erfindung ist in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 ein Brennstoffeinspritzventil mit einem piezoelektrischen Aktor in einer schematischen Schnittdarstellung entsprechend einem Ausführungsbeispiel der Erfindung;
Fig. 2 den in Fig. 1 mit I bezeichneten Ausschnitt eines erfindungsgemäßen Brennstoffeinspritzventils in einer detaillierten Schnittdarstellung, wobei der Schnitt entlang der in Fig. 3 mit II bezeichneten Schnittlinie erfolgt, und
Fig. 3 den in Fig. 1 mit I bezeichneten Ausschnitt aus der in Fig. 1 und 2 mit III bezeichneten Blickrichtung.

### Beschreibung des Ausführungsbeispiels

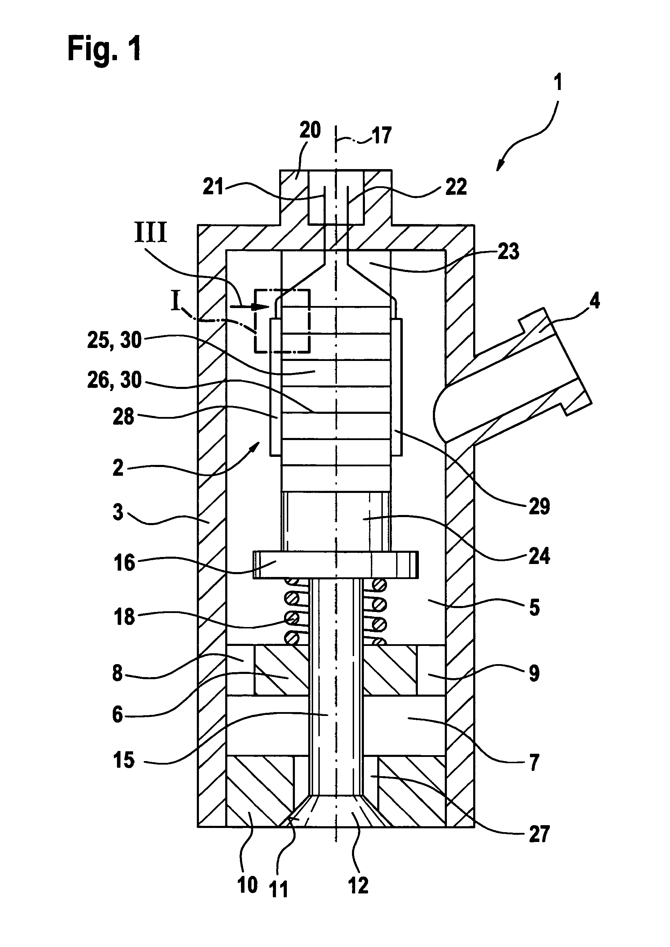

Fig. 1 zeigt ein Brennstoffeinspritzventil 1 mit einem piezoelektrischen Aktor 2 entsprechend einem Ausführungsbeispiel der Erfindung. Das Brennstoffeinspritzventil 1 kann insbesondere als Injektor für Brennstoffeinspritzanlagen von gemischverdichtenden, selbstzündenden Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Der erfindungsgemäße piezoelektrische Aktor 2 eignet sich besonders für solch ein Brennstoffeinspritzventil 1. Das erfindungsgemäße Brennstoffeinspritzventil 1 und der erfindungsgemäße Aktor 2 eignen sich jedoch auch für andere Anwendungsfälle.

Das Brennstoffeinspritzventil 1 weist ein Ventilgehäuse 3 und einen mit dem Ventilgehäuse 3 verbundenen Brennstoffeinlassstutzen 4 auf. An den Brennstoffeinlassstutzen 4 ist eine Brennstoffleitung anschließbar, um Brennstoff in einen im Inneren des Ventilgehäuses 3 vorgesehenen Aktorraum 5 einzuleiten. Der Aktorraum 5 ist durch ein Gehäuseteil 6 von einem ebenfalls im Inneren des Ventilgehäuses 3 vorgesehenen Brennstoffraum 7 getrennt. In dem Gehäuseteil 6 sind Durchlassöffnungen 8, 9 vorgesehen, um den zugeführten Brennstoff über den Aktorraum 5 in den Brennstoffraum 7 zu leiten.

An einem mit dem Ventilgehäuse 3 verbundenen Ventilsitzkörper 10 ist eine Ventilsitzfläche 11 ausgebildet, die mit einem Ventilschließkörper 12 zu einem Dichtsitz zusammenwirkt. Dabei ist der Ventilschließkörper 12 einstückig mit einer Ventilnadel 15 ausgebildet, über die der Ventilschließkörper 12 mit einer im Aktorraum 5 vorgesehenen Druckplatte 16 verbunden ist. Die Ventilnadel 15 wird dabei durch das Gehäuseteil 6 in Richtung einer Achse 17 des Brennstoffeinspritzventils 1 geführt. Mittels der Druckplatte 16 ist die Ventilnadel 15 durch eine Ventilfeder 18 mit einer Schließkraft beaufschlagt, so dass der zwischen dem Ventilschließkörper 12 und der Ventilsitzfläche 11 ausgebildete Dichtsitz geschlossen ist.

An dem Ventilgehäuse 3 ist außerdem ein Anschlusselement 20 zum Anschließen einer elektrischen Zuleitung an das Brennstoffeinspritzventil 1 vorgesehen. Die elektrische Zuleitung kann dabei mittels eines Steckers an elektrische Leitungen 21, 22 angeschlossen werden, die durch das Gehäuse 3 und einen Aktorfuß 23 zu dem Aktor 2 geführt sind. Der Aktor 2 stützt sich über den Aktorfuß 23 an einer Innenseite des Ventilgehäuses 3 ab. Außerdem wirkt der Aktor 2 über einen Aktorkopf 24 entgegen der Kraft der Ventilfeder 18 auf die Druckplatte 16 ein, wobei der Aktor 2 durch die Ventilfeder 18 vorgespannt ist.

Der piezoelektrische Aktor 2 weist eine Vielzahl von keramischen Schichten 25 und eine Vielzahl von zwischen den keramischen Schichten 25 angeordneten Elektrodenschichten 26 auf. Ein Teil der Elektrodenschichten 26 ist mit der elektrischen Leitung 21 verbunden und ein anderer Teil der Elektrodenschichten 26 ist mit der elektrischen Leitung 22 verbunden. Die mit der elektrischen Leitung 21 verbundenen Elektrodenschichten 26 bilden beispielsweise die positiven Elektroden, während die mit der elektrischen Leitung 22 verbundenen Elektrodenschichten 26 die negativen Elektroden bilden.

Über die elektrischen Leitungen 21, 22 kann der Aktor 2 geladen werden, wobei sich dieser in Richtung der Achse 17 ausdehnt, so dass der zwischen dem Ventilschließkörper 12 und der Ventilsitzfläche 11 ausgebildete Dichtsitz geöffnet wird. Dadurch kommt es zum Abspritzen von Brennstoff aus dem Brennstoffraum 7 über einen Ringspalt 27 und den geöffneten Dichtsitz. Durch Entladen des Aktors 2 zieht sich dieser wieder zusammen, so dass der zwischen dem Ventilschließkörper 12 und der Ventilsitzfläche 11 ausgebildete Dichtsitz wieder geschlossen ist.

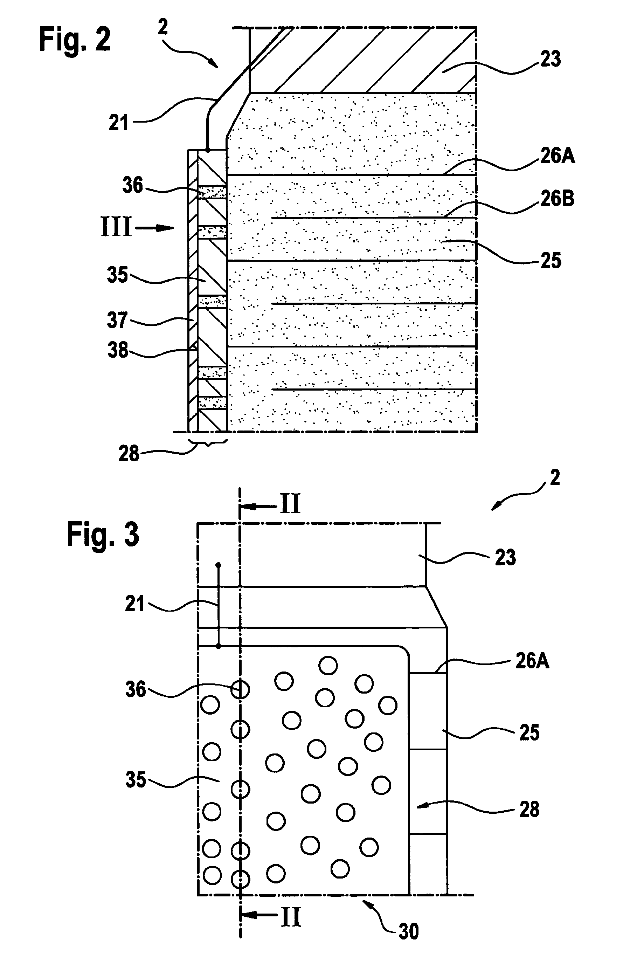

Zur Kontaktierung des Teils der Elektrodenschichten 26, der die positiven Elektroden bildet, ist eine erste Elektrodenanbindung 28 vorgesehen. Für den anderen Teil der Elektrodenschichten 26 ist eine zweite Elektrodenanbindung 29 vorgesehen. Dabei ist die erste Elektrodenanbindung 28 mit der elektrischen Leitung 21 sowie einem Teil der Elektrodenschichten 26 verbunden, während die zweite Elektrodenanbindung 29 mit der elektrischen Leitung 22 und dem anderen Teil der Elektrodenschichten 26 verbunden ist. Außerdem besteht eine mechanische Verbindung der Elektrodenanbindungen 28, 29 mit einem Aktorkörper 30, der die keramischen Schichten 25 und die Elektrodenschichten 26 aufweist, von relativ hoher Festigkeit. Die Ausgestaltung des Aktors 2 ist anhand der Fig. 2 und 3 im Detail weiter beschrieben.

Fig. 2 zeigt den in Fig. 1 mit I bezeichneten Ausschnitt in einer Schnittdarstellung entlang der in Fig. 3 mit II bezeichneten Schnittlinie.

An den Aktorkörper 30 ist der Aktorfuß 23 angefügt, wobei die elektrische Leitung 21 teilweise durch den Aktorfuß 23 verläuft und elektrisch mit der ersten Elektrodenanbindung 28 verbunden ist. Zumindest ein Teil der ersten Elektrodenanbindung 28 wird bereits vor dem Entbindern und Sintern mit dem Aktorkörper 30 in Kontakt gebracht. Der durch die Elektrodenschicht 26A repräsentierte Teil der Elektrodenschichten 26 kann im grünen Zustand des Aktorkörpers 30 durch Strahlen oder dergleichen freigelegt werden. Zumindest ein Teil der ersten Elektrodenanbindung 28 kann auf den Aktorkörper 30 durch ein Siebdruckverfahren oder dergleichen aufgedruckt werden. Die erste Elektrodenanbindung 28 besteht zu diesem Zeitpunkt aus einem rohen Grundmaterial 35 für die erste Elektrodenanbindung 28, in das mehrere aus rohem keramischen Material bestehende Haftbestandteile 36 eingebettet sind. Die Haftbestandteile 36 bestehen vorzugsweise aus dem gleichen keramischen Material wie die keramischen Schichten 25. Der Aktor 2 wird dann entbindert und gesintert, wobei sich Verbindungen zwischen den Haftbestandteilen 36 und den keramischen Schichten 25 von besonders hoher Festigkeit ausbilden. Dadurch ist eine gute Befestigung der ersten Elektrodenanbindung 28 an dem Aktorkörper 30 gewährleistet.

Der durch die Elektrodenschicht 26B repräsentierte Teil der Elektrodenschichten 26, der etwas beabstandet zu der ersten Elektrodenanbindung 28 ausgestaltet ist, ist mit der zweiten Elektrodenanbindung 29 verbunden. Die zweite Elektrodenanbindung 29 kann dabei entsprechend zu der ersten Elektrodenanbindung 28 ausgebildet und mit dem Aktorkörper 30 verbunden sein.

Nach der Sinterung des piezoelektrischen Aktors 2 kann auf dem zusammen mit den keramischen Schichten 25 gesinterten Teil der Elektrodenanbindung 28, der das Grundmaterial 35 und die Haftbestandteile 36 umfasst, zusätzlich ein Leitmittel 37 an einer Oberfläche 38 des Grundmaterials 35 aufgebracht werden. Das Leitmittel 37 kann aus einem elektrisch leitenden Klebstoff, einem elektrisch leitenden Sieb, einem Blech, einem Lot und/oder einer elektrisch leitenden, elastischen Struktur gebildet sein. Das Leitmittel 37 kann allerdings auch entfallen.

Fig. 3 zeigt den in Fig. 1 mit I bezeichneten Ausschnitt aus der in Fig. 1 und 2 mit III bezeichneten Blickrichtung, wobei das in Fig. 2 dargestellte Leitmittel 37 nicht vorgesehen ist.

Die Vielzahl von Haftbestandteilen 36, von denen einer gekennzeichnet ist, sind über das Grundmaterial 35 der ersten Elektrodenanbindung 28 verteilt. In dem dargestellten Ausführungsbeispiel weisen die Haftbestandteile 36 jeweils näherungsweise eine zylindrische Gestalt auf. Die Haftbestandteile 36 können jedoch auch anders ausgebildet sein, insbesondere können sie eine unregelmäßige Geometrie aufweisen. Außerdem können die Haftbestandteile 36 auch eine gitter- oder netzartige Struktur ausbilden. Die Größe der Haftbestandteile 36 und der Anteil in Bezug auf das Grundmaterial 35 ist an die Schichtdicke der ersten Elektrodenanbindung 28 und an die Zusammensetzung des Grundmaterials 35 für die erste Elektrodenanbindung 28 angepasst. Insbesondere ist die Ausgestaltung und Verteilung der Haftbestandteile 36 so gewählt, dass ein zuverlässiger elektrischer Kontakt der elektrischen Leitung 21 über das elektrisch leitende Grundmaterial 35 mit den durch die Elektrodenschicht 26A repräsentierten Elektrodenschichten gewährleistet ist. Dieser elektrische Kontakt kann durch das in der Fig. 2 dargestellte Leitmittel 37 noch verbessert werden. Durch das Einbrennen der ersten Elektrodenanbindung 28 in den Aktorkörper 30 während des Sinterprozesses wird insbesondere eine mechanische Verbindung zwischen den Haftbestandteilen 36 und den keramischen Schichten 25 von hoher Festigkeit ausgebildet. Das gegebenenfalls vorgesehene Leitmittel 37 kann durch Kleben oder Löten auf den gesinterten Teil der ersten Elektrodenanbindung 28 aufgebracht werden, so dass eine Nachbearbeitung für die erste Elektrodenanbindung 28 durch Schleifen oder dergleichen nicht erforderlich ist. Dadurch ist eine kostengünstige Herstellung des piezoelektrischen Aktors 2 möglich.

Die Erfindung ist nicht auf das beschriebene Ausführungsbeispiel beschränkt.

## Patentansprüche

1. Piezoelektrischer Aktor (2), insbesondere Aktor für Brennstoffeinspritzventile, mit einem Aktorkörper (30), der eine Vielzahl von keramischen Schichten (25) und eine Vielzahl von zwischen den keramischen Schichten (25) angeordneten Elektrodenschichten (26) äufweist, und zumindest einer ersten Elektrodenanbindung (28), wobei die erste Elektrodenanbindung (28) mehrere aus zumindest einem keramischen Material gebildete Haftbestandteile (36) aufweist und die Haftbestandteile (36) über die erste Elektrodenanbindung (28) verteilt angeordnet sind und dass zumindest die Haftbestandteile (36) der ersten Elektrodenanbindung (28) mit dem Aktorkörper (30) verbunden sind,
wobei
die Elektrodenschichten (26) des Aktorkörpers (30) zumindest ein elektrisch leitendes Grundmaterial aufweisen, **dadurch gekennzeichnet, dass** eine Zusammensetzung des Grundmaterials (35) der ersten Elektrodenanbindung (28) zumindest im Wesentlichen einer Zusammensetzung des Grundmaterials der Elektrodenschichten (26) entspricht und die Haftbestandteile (36) aus dem gleichen keramischen Material wie die keramischen Schichten (25) bestehen.

2. Piezoelektrischer Aktor nach Anspruch 1,
**dadurch gekennzeichnet,**
**dass** die erste Elektrodenanbindung (28) als außenliegende Elektrodenanbindung (28) ausgestaltet ist

3. Piezoelektrischer Aktor nach Anspruch 1 oder 2,
**dadurch gekennzeichnet,**
**dass** die Haftbestandteile (36) der ersten Elektrodenanbindung (28) in das elektrisch leitende Grundmaterial (35) zumindest teilweise eingebettet sind.

4. Piezoelektrischer Aktor nach einem der Ansprüche 1 bis 3,
**dadurch gekennzeichnet,**
**dass** die Haftbestandteile (36) der ersten Elektrodenanbindung (28) aus zumindest einem zumindest auf einem Bleizirkonattitanat basierenden keramischen Material gebildet sind.

5. Piezoelektrischer Aktor nach einem der Ansprüche 1 bis 3,
**dadurch gekennzeichnet,**
**dass** die Haftbestandteile (36) der ersten Elektrodenanbindung (28) aus zumindest einem auf zumindest einem Bariumtitanat basierenden keramischen Material ausgebildet sind.

6. Piezoelektrischer Aktor nach einem der Ansprüche 1 bis 5,
**dadurch gekennzeichnet,**
**dass** die aus dem keramischen Material gebildeten Haftbestandteile (36) der ersten Elektrodenanbindung (28) zumindest teilweise mit den keramischen Schichten (25) des Aktorkörpers (30) durch Sintern verbunden sind.

7. Piezoelektrischer Aktor nach einem der Ansprüche 1 bis 6,
**dadurch gekennzeichnet,**
**dass** die erste Elektrodenanbindung (28) zumindest ein elektrisch leitendes Leitmittel (37) aufweist.

8. Piezoelektrischer Aktor nach Anspruch 7,
**dadurch gekennzeichnet,**
**dass** das Leitmittel (37) aus einem elektrisch leitenden Klebstoff, einem elektrisch leitenden Sieb, einem Blech, einem Lot und/oder einer elektrisch leitenden, elastischen Struktur gebildet ist.

9. Brennstoffeinspritzventil (1), insbesondere Injektor für Brennstoffeinspritzanlagen von luftverdichtenden, selbstzündenden Brennkraftmaschinen, mit einem piezoelektrischen Aktor (2) nach einem der Ansprüche 1 bis 8 und einem von dem Aktor (2) betätigbaren Ventilschließkörper (12), der mit einer Ventilsitzfläche (11) zu einem Dichtsitz zusammenwirkt.

10. Verfahren zur Herstellung eines piezoelektrischen Aktors (2) nach einem der Ansprüche 1 bis 8, mit einem Aktorkörper (30), der eine Vielzahl von keramischen Schichten (25) und eine Vielzahl von zwischen den keramischen Schichten (25) angeordneten Elektrodenschichten (26) aufweist, und zumindest einer mit einem ersten Teil der Elektrodenschichten (26) verbundenen ersten Elektrodenanbindung (28), wobei das Verfahren folgende Verfahrensschritte umfasst:
- Einbringen eines rohen keramischen Materials (36) in ein rohes Grundmaterial (35) für die erste Elektrodenanbindung (28);
- Aufbringen des rohen Grundmaterials (35) für die erste Elektrodenanbindung (28) mit dem in dem rohen Grundmaterial (35) für die erste Elektrodenanbindung (28) enthaltenen rohen keramischen Material (36) auf einen rohen Aktorkörper (30), der rohe keramische Schichten (25) und rohe Elektrodenschichten (26) aufweist, zur zumindest teilweisen Ausbildung der ersten Elektrodenanbindung (28);
- Sintern des Aktorkörpers (30) zusammen mit dem auf den Aktorkörper (30) aufgebrachten Grundmaterial für die erste Elektrodenanbindung (28) und dem in dem Grundmaterial (35) für die erste Elektrodenanbindung (28) vorgesehenen rohen keramischen Material (36), wobei das in dem Grundmaterial (35) für die erste Elektrodenanbindung (28) vorgesehene rohe keramische Material (36) zumindest teilweise mit den keramischen Schichten (25) des Aktorkörpers (30) verbunden wird.

## Claims

1. Piezoelectric actuator (2), in particular an actuator for fuel injection valves, with an actuator body (30), which comprises a multiplicity of ceramic layers (25) and a multiplicity of electrode layers (26) arranged between the ceramic layers (25), and at least a first electrode connection (28), the first electrode connection (28) comprising a number of detention components (36) that are formed from at least one ceramic material and the detention components (36) being arranged such that they are distributed over the first electrode connection (28) and at least the detention components (36) of the first electrode connection (28) being connected to the actuator body (30), wherein the electrode layers (26) of the actuator body (30) comprise at least one electrically conducting base material, **characterized in that** a composition of the base material (35) of the first electrode connection (28) corresponds at least substantially to a composition of the base material of the electrode layers (26) and the detention components (36) consist of the same ceramic material as the ceramic layers (25).

2. Piezoelectric actuator according to Claim 1, **characterized in that** the first electrode connection (28) is formed as an external electrode connection (28).

3. Piezoelectric actuator according to Claim 1 or 2, **characterized in that** the detention components (36) of the first electrode connection (28) are at least partially embedded in the electrically conducting base material (35).

4. Piezoelectric actuator according to one of Claims 1 to 3, **characterized in that** the detention components (36) of the first electrode connection (28) are formed from at least one ceramic material based on at least one lead zirconate titanate.

5. Piezoelectric actuator according to one of Claims 1 to 3, **characterized in that** the detention components (36) of the first electrode connection (28) are formed from at least one ceramic material based on at least one barium titanate.

6. Piezoelectric actuator according to one of Claims 1 to 5, **characterized in that** the detention components (36) of the first electrode connection (28) that are formed from the ceramic material are at least partially connected to the ceramic layers (25) of the actuator body (30) by sintering.

7. Piezoelectric actuator according to one of Claims 1 to 6, **characterized in that** the first electrode connection (28) comprises at least one electrically conducting conductive means (37).

8. Piezoelectric actuator according to Claim 7, **characterized in that** the conductive means (37) is formed by an electrically conducting adhesive, an electrically conducting mesh, a metal sheet, a solder and/or an electrically conducting, elastic structure.

9. Fuel injection valve (1), in particular an injector for fuel injection systems of compressed-air, compression-ignition internal combustion engines, with a piezoelectric actuator (2) according to one of Claims 1 to 8 and a valve closing body (12), which can be actuated by the actuator (2) and interacts with a valve seat face (11) to form a sealing seat.

10. Method for producing a piezoelectric actuator (2) according to one of Claims 1 to 8, with an actuator body (30), which comprises a multiplicity of ceramic layers (25) and a multiplicity of electrode layers (26) arranged between the ceramic layers (25), and at least a first electrode connection (28), connected to a first part of the electrode layers (26), the method comprising the following method steps:
- introducing a raw ceramic material (36) into a raw base material (35) for the first electrode connection (28);
- applying the raw base material (35) for the first electrode connection (28) with the raw ceramic material (36) contained in the raw base material (35) for the first electrode connection (28) to a raw actuator body (30), which comprises raw ceramic layers (25) and raw electrode layers (26), for the at least partial forming of the first electrode connection (28);
- sintering the actuator body (30) together with the base material applied to the actuator body (30) for the first electrode connection (28) and the raw ceramic material (36) provided in the base material (35) for the first electrode connection (28), wherein the raw ceramic material (36) provided in the base material (35) for the first electrode connection (28) is at least partially connected to the ceramic layers (25) of the actuator body (30).

## Revendications

1. Actionneur piézo-électrique (2), notamment actionneur pour des injecteurs de carburant comprenant un corps d'actionneur (30) ayant un grand nombre de couches en matière céramique (25) et un grand nombre de couches d'électrodes (26) installées entre les couches de matière céramique (25) et au moins une première fixation d'électrodes (28), cette première fixation d'électrode (28) comportant plusieurs pièces de fixation (36) en matière céramique et des pièces de fixation (36) sont réparties sur la première fixation d'électrode (28) et
au moins les pièces de fixation (36) de la première fixation d'électrode (28) sont reliées au corps (30) de l'actionneur,
les couches d'électrodes (26) du corps (30) de l'actionneur ayant au moins une matière de base conductrice d'électricité,
**caractérisé en ce qu'**
une composition de la matière de base (35) de la première fixation d'électrode (28) correspond au moins pour l'essentiel à une composition de la matière de base des couches d'électrodes (26) et les pièces de fixation (36) sont réalisées dans la même matière céramique que les couches de matière céramique (25).

2. Actionneur piézo-électrique selon la revendication 1,
**caractérisé en ce que**
la première fixation d'électrode (28) est réalisée sous la forme d'une fixation d'électrode (28) située à l'extérieur.

3. Actionneur piézo-électrique selon la revendication 1 ou 2,
**caractérisé en ce que**
les pièces de fixation (36) de la première fixation d'électrode (28) sont au moins en partie intégrées dans la matière de base (35) conductrice d'électricité.

4. Actionneur piézo-électrique selon l'une des revendications 1 à 3,
**caractérisé en ce que**
les pièces de fixation (36) de la première fixation d'électrode (28) sont réalisées dans au moins une matière céramique au moins à base de zirconate-titanate de plomb.

5. Actionneur piézo-électrique selon l'une des revendications 1 à 3,
**caractérisé en ce que**
les pièces de fixation (36) de la première fixation d'électrode (28) sont réalisées au moins en une matière céramique au moins à base de titanate de baryum.

6. Actionneur piézo-électrique selon l'une des revendications 1 à 5,
**caractérisé en ce que**
les pièces de fixation (36) de la première fixation d'électrode (28), réalisées en matière céramique, sont reliées au moins en partie aux couches de matière céramique (25) du corps d'actionneur (30) par frittage.

7. Actionneur piézo-électrique selon l'une des revendications 1 à 6,
**caractérisé en ce que**
la première fixation d'électrode (28) comporte au moins un moyen conducteur électrique (37).

8. Actionneur piézo-électrique selon la revendication 7,
**caractérisé en ce que**
le moyen conducteur (37) est un adhésif conducteur électrique, un tamis conducteur électrique, une tôle, une soudure et/ou une structure élastique conductrice électrique.

9. Injecteur de carburant (1), notamment injecteur pour des installations d'injection de carburant de moteurs à combustion interne à compression d'air et auto-allumage comprenant un actionneur piézo-électrique (2) selon l'une des revendications 1 à 8 et un organe d'obturation de soupape (12) commandé par l'actionneur (2), et coopérant avec une surface de siège de soupape (11) pour former un siège d'étanchéité.

10. Procédé de fabrication d'un actionneur piézo-électrique (2) selon l'une des revendications 1 à 8, comprenant un corps d'actionneur (30) ayant un grand nombre de couches de matière céramique (25) et un grand nombre de couches d'électrodes (26) installées entre les couches de matière céramique (25) et au moins une première fixation d'électrodes (28) reliant une première partie des couches d'électrodes (26),
le procédé comprenant les étapes de procédé suivantes :
- introduction d'une matière céramique brute (36) dans une matière de base (35), brute pour la première fixation d'électrodes (28),
- application de la matière de base brute (35) pour la première fixation d'électrodes (28) avec la matière céramique brute (36) contenue dans la matière de base brute (35) pour la première fixation d'électrode (28) sur un corps d'actionneur brut (30) comprenant les couches de céramique brutes (25), les couches d'électrodes brutes (26), pour réaliser au moins en partie la première fixation d'électrodes (28),
- frittage du corps d'actionneur (30) avec la matière de base appliquée sur le corps d'actionneur (30) pour la première fixation d'électrodes (28) et avec la matière céramique brute (36) prévue dans la matière de base (35) pour la première fixation d'électrodes (28),
la matière céramique brute (36) prévue dans la matière de base (35) pour la première fixation d'électrodes (28) étant fixée au moins en partie aux couches de matière céramique (25) du corps d'actionneur (30).
